# EUROPEAN PATENT APPLICATION

(11) **EP 4 517 613 A1**
(43) Date of publication of application: **05.03.2025**
(21) Application number: 24197692.7
(22) Date of filing: 30.08.2024
(51) Int. Cl.: G06Q 10/04, G06Q 10/06, G06Q 10/063, G06Q 10/0633

(54) **PROCESSING APPARATUS, SUBSTRATE PROCESSING APPARATUS, DISPLAY METHOD, SUBSTRATE PROCESSING METHOD, METHOD OF MANUFACTURING SEMICONDUCTOR DEVICE AND PROGRAM**

(30) Priority: 31.08.2023 JP 2023141653
(71) Applicant: Kokusai Electric Corp., Tokyo 1010045 (JP)
(72) Inventor: TAKEBAYASHI, Yuri, Toyama-shi, 939-2393 (JP); MORI, Shinichiro, Toyama-shi, 939-2393 (JP)
(74) Representative: Verscht, Thomas Kurt Albert

(57) **Abstract**

There is provided a technique capable of easily identifying a recipe and combination information associated with the recipe in a processing apparatus. There is provided a technique that includes: a controller configured to be capable of controlling a screen to display a recipe selection image including a recipe selection area and a recipe editing image including a management information display area and a combination information editing area, wherein the recipe selection area is configured such that a plurality of indicators indicating a plurality of recipes including a plurality of sub-recipes or a plurality of main recipes are displayed therein, wherein the management information display area is configured such that, when one of the plurality of indicators is selected on the recipe selection image, management information of one of the plurality of recipes associated with the one of the plurality of indicators selected on the recipe selection image is capable of being displayed therein, and wherein the combination information editing area is configured such that combination information linked to the one of the plurality of recipes displayed in the management information display area is capable of being displayed therein.

## Description

### [Technical Field]

The present disclosure relates to a processing apparatus, a substrate processing apparatus, a display method, a substrate processing method, a method of manufacturing a semiconductor device and a program.

### [Related Art]

For example, according to Patent Document 1, a technique for displaying a recipe and combination information thereof may be used.

### [Related Art Document]

### [Patent Document]

Patent Document 1: International Patent Publication No. WO 2019/186649

### [Disclosure]

### [Technical Problem]

According to the present disclosure, there is provided a technique capable of easily identifying a recipe and combination information associated with the recipe in a processing apparatus.

### [Technical Solution]

According to an embodiment of the present disclosure, there is provided a technique that includes a controller configured to be capable of controlling a screen to display a recipe selection image including a recipe selection area and a recipe editing image including a management information display area and a combination information editing area, wherein the recipe selection area is configured such that a plurality of indicators indicating a plurality of recipes including a plurality of sub-recipes or a plurality of main recipes are displayed therein, wherein the management information display area is configured such that, when one of the plurality of indicators is selected on the recipe selection image, management information of one of the plurality of recipes associated with the one of the plurality of indicators selected on the recipe selection image is capable of being displayed therein, and wherein the combination information editing area is configured such that combination information linked to the one of the plurality of recipes displayed in the management information display area is capable of being displayed therein.

### [Advantageous Effects]

According to some embodiments of the present disclosure, it is possible to easily identify a recipe and combination information associated with the recipe in a processing apparatus.

### [Brief Description of Drawings]

FIG. 1 is a diagram schematically illustrating a perspective view of a substrate processing apparatus according to one or more embodiments of the present disclosure.
FIG. 2 is a diagram schematically illustrating a vertical cross-section of a process furnace of the substrate processing apparatus shown in FIG. 1.
FIG. 3 is a block diagram schematically illustrating a configuration of a control structure and related components of the substrate processing apparatus shown in FIG. 1.
FIG. 4 is a diagram schematically illustrating an example in which a recipe selection image (which includes a recipe selection area and a recipe editing area) related to a controller of the control structure is displayed.
FIG. 5 is a diagram schematically illustrating an example in which a recipe selection image (which includes the recipe selection area and a second recipe selection area) related to the controller of the control structure is displayed.
FIG. 6 is a diagram schematically illustrating an example in which a recipe editing image (which includes a management information display area and a combination information editing area) related to the controller of the control structure is displayed.

### [Detailed Description]

### <Embodiments of Present Disclosure>

Hereinafter, one or more embodiments (also simply referred to as "embodiments") according to the technique of the present disclosure will be described with reference to the drawings. In the present specification, the drawings are all schematic. For example, a size of each component and a size ratio of each component shown in the drawing may not always reflect the actual ones of an actual apparatus. Further, symbols or reference numerals (which appear in common in each drawing) may indicate common configurations even when they are not mentioned in the description of each drawing.

Further, in the following description, an operator refers to a person who uses a substrate processing apparatus or a person who processes a substrate using the substrate processing apparatus.

### <Configuration>

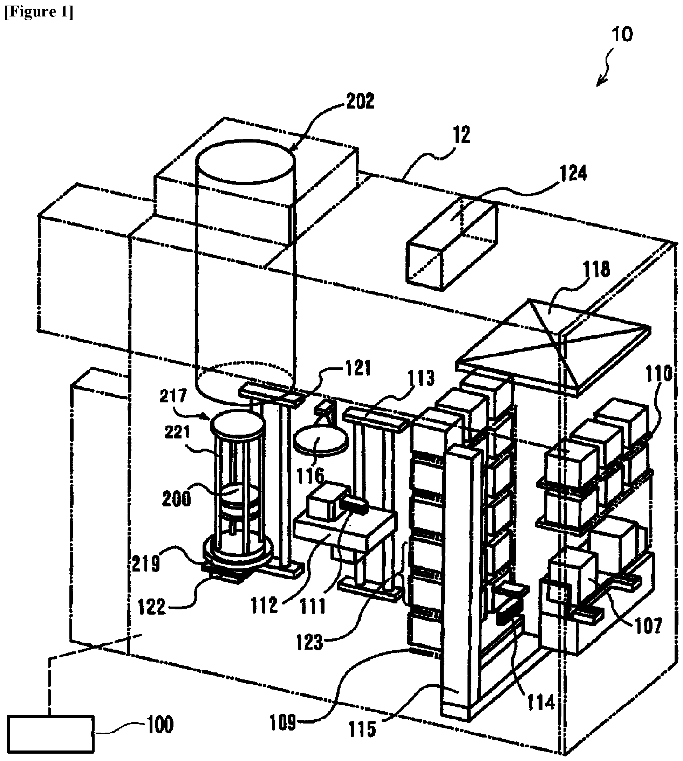

A configuration of a substrate processing apparatus 10 according to the present embodiments will be described with reference to FIGS. 1 to 3. As shown in FIG. 1, the substrate processing apparatus 10 according to the embodiments of the present disclosure includes a housing 12. In the substrate processing apparatus 10, a cassette 107 configured to store a plurality of substrates 200 may be used. Hereinafter, each of the plurality of substrates 200 may also be referred to as a "substrate 200". Further, a plurality of cassettes including the cassette 107 may be used in the substrate processing apparatus 10. Hereinafter, the plurality of cassettes including the cassette 107 may also be simply referred to as "the plurality of cassettes 107" or "cassettes 107". For example, the substrate 200 is made of a material such as silicon (Si). A cassette shelf 109 is provided inside the housing 12. The cassette 107 can be transferred (or loaded) into or transferred (or unloaded) out of the cassette shelf 109 by an in-process transfer device (not shown).

The cassette shelf 109 is provided in the housing 12 to be located at a substantially central portion of the housing 12 in a front-rear direction. The cassette shelf 109 is configured to store the plurality of cassettes 107 in a plurality of rows and a plurality of stages. The cassette shelf 109 is provided with a plurality of transfer shelves 123 on which the cassettes 107 can be stored. Hereinafter, each of the plurality of transfer shelves 123 may also be referred to as a "transfer shelf 123". Further, a spare cassette shelf 110 is provided inside the housing 12 of the substrate processing apparatus 10, and is configured to store the cassettes 107 in a spare manner. For example, a cassette elevator 115 capable of moving up and down while holding (or supporting) the cassette 107 and a cassette transfer device 114 are further provided inside the housing 12. The cassette 107 is transferred between the cassette shelf 109 and the spare cassette shelf 110 by consecutive operations of the cassette elevator 115 and the cassette transfer device 114 controlled by a controller 101 described later.

Behind the cassette shelf 109, a substrate transfer device 112 capable of rotating and linearly moving the substrate 200 in a horizontal direction and a transfer elevator 113 capable of elevating and lowering the substrate transfer device 112 are provided. More specifically, the transfer elevator 113 is provided at a right end of the housing 12. By consecutive operations of the transfer elevator 113 and the substrate transfer device 112, the substrate 200 can be transferred (or charged) into or transferred (or discharged) out of a boat 217 described later while tweezers 111 of the substrate transfer device 112 are used as a support structure (or a placement structure) for the substrate 200.

A process furnace 202 is provided above a rear portion of the housing 12. A lower end of the process furnace 202 is configured to be opened and closed by a furnace opening shutter 116. A boat elevator 121 serving as an elevating structure configured to elevate or lower the boat 217 with respect to the process furnace 202 is provided below the process furnace 202. Further, a seal cap 219 serving as a lid is horizontally provided on an elevating stage 122 serving as a connector connected to an elevating platform of the boat elevator 121. The seal cap 219 is configured to support the boat 217 vertically and is further configured to be capable of closing the lower end of the process furnace 202. The boat 217 serving as a substrate retainer is provided with a plurality of boat columns 221, and is configured to horizontally hold (support) the plurality of substrates 200 (for example, about 50 substrates to 150 substrates) aligned vertically in a state where centers of the substrates 200 are aligned.

As shown in FIG. 1, a clean air supplier (which is a clean air supply structure or a clean air supply system) 118 constituted by a supply fan and a dust filter is provided at an upper portion of the housing 12. The clean air supplier 118 is configured to supply clean air (which is an atmosphere obtained by purifying outside air flowing in through a duct 124). The clean air supplier 118 is further configured to circulate the clean air inside the housing 12.

For example, as shown in FIG. 1, the substrate processing apparatus 10 is provided with a control structure (which is a control apparatus) 100 described later. The control structure 100 is electrically connected to components constituting the substrate processing apparatus 10. Each component is operated according to an instruction from the control structure 100.

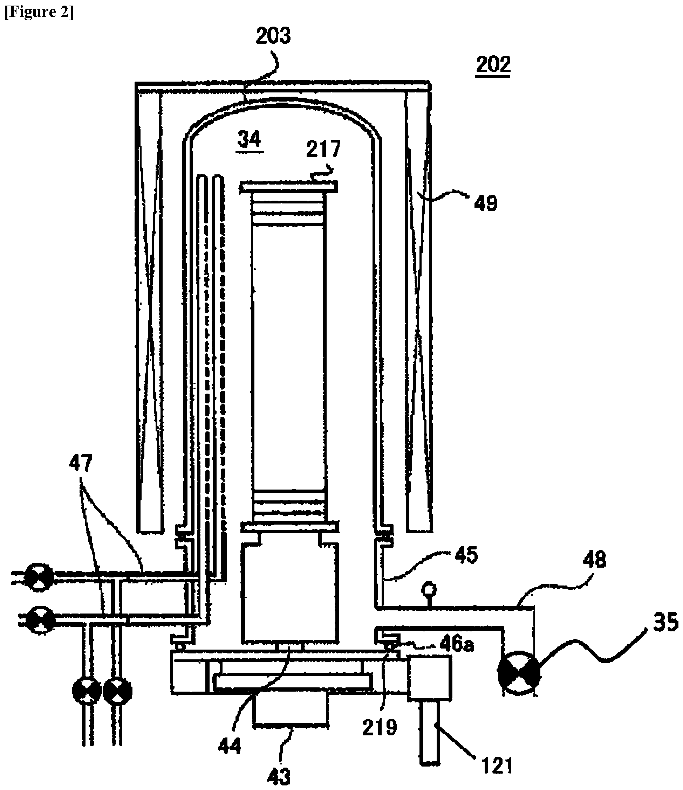

Subsequently, the process furnace 202 mentioned above will be described in detail with reference to FIG. 2.

### <Process Furnace>

As shown in FIG. 2, the process furnace 202 includes a reaction tube 203. For example, the reaction tube 203 is made of a heat resistant and non-metallic material such as quartz (SiO₂) and silicon carbide (SiC), and is of a cylindrical shape with a closed upper end and an open lower end.

For example, a process chamber 34 in which the substrate 200 such as a wafer is processed is provided inside the reaction tube 203. In other words, the substrate processing apparatus 10 includes the process chamber 34. The boat 217 serving as the substrate retainer is inserted into the process chamber 34 through the open lower end of the reaction tube 203. Thereby, the substrates 200 supported by the boat 217 in a horizontal orientation are accommodated in the process chamber 34 while the substrates 200 are vertically aligned in a multistage manner. The boat 217 accommodated in the process chamber 34 is configured to capable of being rotated with the substrates 200 loaded therein by rotating a rotating shaft 44 by a rotator (which is a rotating structure) 43 while maintaining the process chamber 34 airtight.

A manifold 45 is disposed below the reaction tube 203 in a manner concentric with the reaction tube 203. For example, the manifold 45 is made of a metal material such as stainless steel, and is of a cylindrical shape with open upper and lower ends. The manifold 45 is configured to support the reaction tube 203 vertically from thereunder. In other words, the reaction tube 203 constituting the process chamber 34 is vertically supported via the manifold 45 to constitute the process furnace 202. The lower end of the manifold 45 is configured to be airtightly sealed by the seal cap 219 when the boat elevator 121 is elevated. A seal 46a such as an O-ring configured to airtightly seal the process chamber 34 is provided between the lower end of the manifold 45 and the seal cap 219.

In addition, a gas introduction pipe 47 through which a gas such as a source gas and a purge gas is introduced into the process chamber 34 and an exhaust pipe 48 through which the gas in the process chamber 34 is exhausted are connected to the manifold 45. A pressure (inner pressure) of the process chamber 34 is controlled by adjusting an APC (automatic pressure controller) valve 35 based on a detection result of a pressure sensor (not shown).

A heater structure 49 (which is a heating apparatus or a heater) is disposed around an outer periphery of the reaction tube 203 in a manner concentric with the reaction tube 203. The heater structure 49 is configured to heat the process chamber 34 such that a uniform or predetermined temperature distribution of the process chamber 34 can be obtained throughout the process chamber 34.

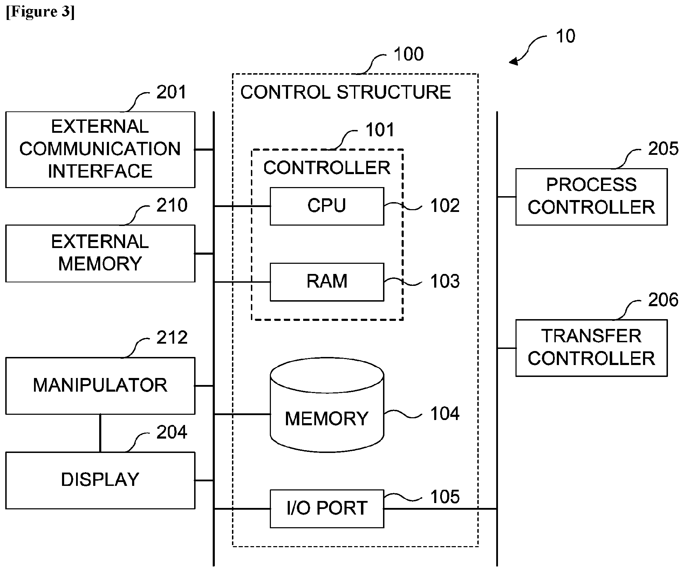

FIG. 3 is a block diagram illustrating an example of a functional configuration of the control structure 100 included in the substrate processing apparatus 10 according to the present embodiments.

As shown in FIG. 3, the substrate processing apparatus 10 includes the control structure 100 (which is a main controller), an external communication interface 201, an external memory 210, a manipulator 212, a display 204, a process controller 205 and a transfer controller 206.

The control structure 100 further includes the controller 101, a memory 104, and an I/O interface (also referred to as an "I/O port") 105. The controller 101 includes a CPU (Central Processing Unit) 102 and a RAM (Random Access Memory) 103.

The control structure 100 is connected to the manipulator 212, and is further connected to the process controller 205 and the transfer controller 206 via the I/O port 105. The control structure 100 is electrically connected to each of the process controller 205 and the transfer controller 206 via the I/O port 105. Thereby, for example, each piece of data can be transmitted or received and each file can be downloaded or uploaded between the control structure 100 and each of the process controller 205 and the transfer controller 206.

The control structure 100 is connected to a host computer (not shown) via the external communication interface 201. Therefore, even when the substrate processing apparatus 10 is installed in a clean room, the host computer can be disposed at a location such as an office outside the clean room. In addition, the external memory 210 (which serves as a mounting structure which a recording medium such as a USB (Universal Serial Bus) memory is installed on or removed from) is connected to the control structure 100.

For example, the manipulator 212 is configured as a so-called touch panel which is integrated with the display 204 as a single structure or which is connected to the display 204 via a connector such as a video cable. Various operation screens for operating the substrate processing apparatus 10 can be displayed on the display 204. For example, the operation screen may include a screen through which a state of a substrate process system controlled by the process controller 205 and a state of a substrate transfer system controlled by the transfer controller 206 can be checked. The display 204 may be provided with various operation buttons serving as an input interface through which an operation instruction can be input to the substrate process system and the substrate transfer system. The manipulator 212 displays information generated in the substrate processing apparatus 10 on the display 204 via the operation screen. For example, the manipulator 212 outputs the information displayed on the display 204 to a device such as the USB memory inserted in the external memory 210. The manipulator 212 accepts (or receives) input data (input instruction) from the operation screen displayed on the display 204 and transmits the input data to the control structure 100. Further, the manipulator 212 is configured to receive an instruction (control instruction) to execute an appropriate substrate processing recipe (also referred to as a "process recipe") from recipes expanded in the RAM 103 or recipes stored in the memory 104, and is further configured to transmit the instruction to the control structure 100. In the present embodiments, the manipulator 212 and the display 204 are provided separately from the control structure 100. However, the manipulator 212 and the display 204 may be integrated into a single body to be included in the control structure 100.

Although not shown in FIG. 3, the process controller 205 may include a temperature controller, a gas flow rate controller and a pressure controller. Each of the temperature controller, the gas flow rate controller and the pressure controller constitutes a sub-controller and is electrically connected to the process controller 205. Thereby, for example, each piece of data can be transmitted or received and each file can be downloaded or uploaded between the process controller 205 and each of the temperature controller, the gas flow rate controller and the pressure controller. The process controller 205 and each sub-controller (the temperature controller, the gas flow rate controller and the pressure controller) may be configured separately or integrally.

Although not shown in FIG. 3, the transfer controller 206 may include a structure controller. The structure controller is configured to control each of a drive system, a rotation system and an elevating system of the substrate processing apparatus 10. For example, the transfer controller 206 is configured to control transfer operations of the cassette shelf 109, the boat elevator 121, the cassette transfer device 114, the substrate transfer device 112, the boat 217 and the rotator 43.

The control structure 100 is configured as a computer including the CPU 102, the RAM 103, the memory 104 and the I/O port 105. In the memory 104, for example, recipe files such as recipes in which process conditions and process procedures are defined, control program files for executing the recipe files, parameter data (setting value files) for setting the process conditions and the process procedures, error processing program files and parameter data for an error processing may be stored. Further, in the memory 104, for example, various icon files (not shown) and various screen files (not shown) including an input screen through which process parameters are input may be further stored. For example, the control structure 100 is connected to a network such as the Internet, a LAN (Local Area Network) and a WAN (Wide Area Network) using the external communication interface 201. Thereby, the control structure 100 is capable of communicating with an external apparatus via the network.

In the present embodiments, a main recipe and a sub-recipe (which are described later) may be collectively referred to as a "recipe". That is, the recipe may be used as a general term for the main recipe and the sub-recipe. Thus, in the following description, the term "recipe" may refer to the main recipe alone, may refer to the sub-recipe alone, or may refer to both of the main recipe and the sub-recipe.

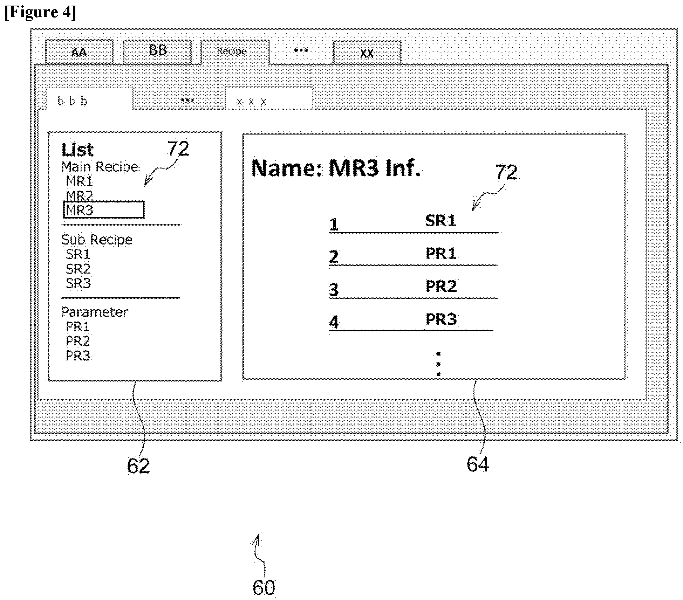

The main recipe is a recipe that specifies a series of procedures from a start of a processing of the substrate 200 (that is, from a loading step of loading the substrate 200 into the boat 217) to an end of the processing of the substrate 200 (that is, to an unloading step of unloading the substrate 200 from the boat 217) in process procedures for the substrate 200 described below. When a plurality of main recipes are provided, each main recipe is specified by citing a single sub-recipe related thereto and a plurality pieces of parameter data, as shown in a recipe selection area 62 (which will be described later) in FIG. 4.

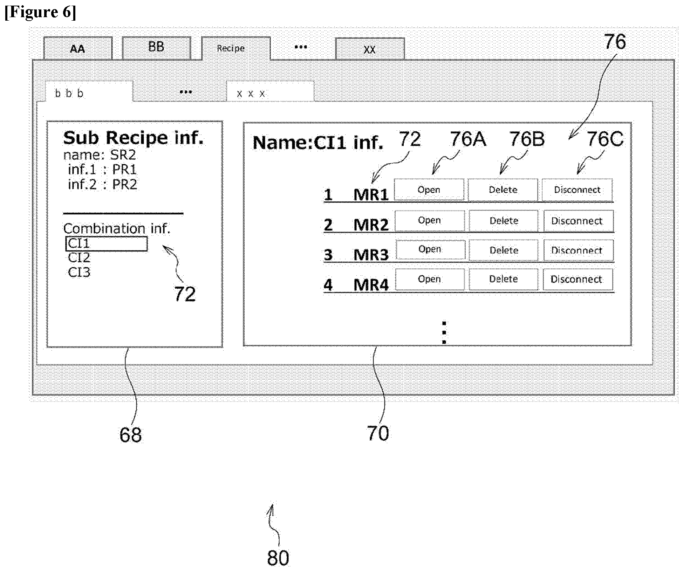

The sub-recipe is a recipe that specifies more detailed procedures of steps in process procedures for the substrate 200 described below. The sub-recipe can be cited (or referenced) by one or more of the plurality of main recipes, as shown in a combination information editing area 70 (which will be described later) in FIG. 6.

According to the present embodiments, for example, a maximum number of steps capable of being specified in the sub-recipe is set to be greater than a maximum number of steps capable of being specified in the main recipe. In other words, the sub-recipe is configured such that the steps can be specified in more detail than the main recipe.

According to the present embodiments, for example, the sub-recipe is cited in the main recipe as described above. Thus, when the operator edits the sub-recipe cited in the main recipe, a change in the sub-recipe as a result of editing the sub-recipe may affect the main recipe. In other words, the sub-recipe is configured to be linked to the main recipe.

For example, as the memory 104, a component such as a hard disk drive (HDD), a solid state drive (SSD) and a flash memory may be used. In the memory 104, a program for executing each procedure according to the present embodiments can be stored.

For example, the program mentioned above may be installed in the substrate processing apparatus 10 in advance. For example, the program may be prepared by appropriately installing the program (which may be recorded on a non-volatile recording medium or distributed via the network) in the substrate processing apparatus 10. For example, as the non-volatile recording medium, a component such as a CD-ROM, a magneto-optical disk, a HDD, a DVD-ROM, a flash memory, a memory card and a USB may be used.

The CPU 102 of the substrate processing apparatus 10 according to the present embodiments can function as the controller 101 by writing the program stored in the memory 104 into the RAM 103 and executing the program.

Subsequently, operations of the substrate processing apparatus 10 and the controller 101 in a substrate processing method according to the present embodiments will be described.

### <Transfer Step>

As shown in FIG. 1, the controller 101 loads the cassette 107 through a cassette loading/unloading port. Thereafter, the controller 101 transfers the cassette 107 from the cassette shelf 109 (or the spare cassette shelf 110) to the transfer shelf 123, or transfers the cassette 107 directly to the transfer shelf 123.

### <Loading Step>

After the cassette 107 is transferred to the transfer shelf 123, the controller 101 picks up the substrates 200 from the cassette 107 through a substrate loading/unloading port using the tweezers 111 of the substrate transfer device 112, and loads (or charges) each of the substrates 200 into the boat 217. As a result, the boat 217 holds (supports) the plurality of substrates 200 in a stacked manner with a gap between each of the substrates 200 in the vertical direction.

After a predetermined number of the substrates 200 are loaded into the boat 217, the controller 101 causes the furnace opening shutter 116 to open the lower end of the process furnace 202, which has been closed by the furnace opening shutter 116. Subsequently, the controller 101 loads (transfers) the boat 217 holding the substrates 200 into the process furnace 202 by elevating the seal cap 219 by the boat elevator 121. In other words, the controller 101 operates the boat elevator 121 to load the boat 217 holding the substrates 200 (which are unprocessed) from a transfer chamber into the process chamber 34. As a result, the seal cap 219 seals the lower end of the manifold 45 via the seal 46a.

### <Processing Step>

After the substrates 200 are loaded into the boat 217, the controller 101 processes the substrates 200 (which are unprocessed) held by the boat 217 loaded into the process chamber 34 in accordance with a recipe that defines the process conditions for the substrates 200. Specifically, when performing a film forming process by a thermal CVD (chemical vapor deposition) reaction, for example, the controller 101 uses the exhaust pipe 48 to exhaust the process chamber 34 and adjusts the APC valve 35 such that the pressure (inner pressure) of the process chamber 34 reaches and is maintained at a desired pressure (vacuum level). Then, the controller 101 uses the heater structure 49 to heat the process chamber 34 such that a temperature (inner temperature) of the process chamber 34 reaches and is maintained at a desired temperature, and operates the rotator 43 to rotate the boat 217, in other words, to rotate the substrates 200. The controller 101 continuously rotates the substrates 200 until the substrates 200 are unloaded, which will be described later. Further, by supplying the gas such as the source gas and the purge gas to the process chamber 34 by the gas introduction pipe 47, the controller 101 forms a film on a surface of each of the substrates 200 held in the boat 217 by using a reaction such as a thermal decomposition reaction.

After the film is formed on the surface of the substrate 200, the controller 101 stops heating the process chamber 34 by the heater structure 49, and thereby lowers a temperature of each of the substrates 200 (which are processed) to a predetermined temperature. Then, when a preset time has elapsed from a point at which the controller 101 stops heating the process chamber 34 by the heater structure 49, the controller 101 stops supplying the gas to the process chamber 34 and starts supplying an inert gas to the process chamber 34. As a result, the controller 101 replaces an inner atmosphere of the process chamber 34 with the inert gas and returns the pressure of the process chamber 34 to a normal pressure.

The controller 101 executes the processing step mentioned above according to the recipe (more specifically, the main recipe and the sub-recipe). The processing step can be determined by the operator who performs the film forming process on the substrates 200 by appropriately selecting the main recipe among the plurality of main recipes.

For example, the recipe is stored in the memory 104, and the controller 101 acquires the recipe in a substrate processing of processing the substrates 200, and controls the substrate processing in accordance with the process conditions defined in the recipe. The recipe may be stored in the memory 104, may be read from the USB memory, a CD or a DVD via the external memory 210, or may be acquired from the external apparatus via the external communication interface 201.

### <Unloading Step>

After the processing step is completed, the controller 101 lowers the seal cap 219 by elevating and lowering the boat elevator 121 such that the lower end of the manifold 45 is opened. Further, the controller 101 unloads the boat 217 holding the substrates 200 (which are processed) through the lower end of the manifold 45 to an outside of the process chamber 34 (boat unloading step).

### <Transfer Step after Unloading>

After the substrates 200 in the boat 217 have been cooled to a predetermined temperature (for example, about a room temperature), the controller 101 uses the substrate transfer device 112 arranged in the transfer chamber to discharge the substrates 200 from the boat 217. Then, the controller 101 performs a substrate discharging operation to transfer and store the substrates 200 (which are processed and discharged from the boat 217) into the cassette 107 (which is empty). Thereafter, the controller 101 transfers (unloads) the cassette 107 accommodating the substrates 200 (which are processed) to an outside of the housing 12 in a manner reverse to that of loading the cassette 107 in the transfer step described above. The substrates 200 unloaded to the outside of the housing 12 are then transferred to a semiconductor device manufacturing apparatus and incorporated into a semiconductor device.

Further, the substrate processing method of processing the substrate 200 (and a method of manufacturing the semiconductor device) according to the present embodiments may include a step of processing the substrate 200 based on the recipe displayed on a recipe selection image 60, which will be described later. In other words, the substrate processing method (and the method of manufacturing the semiconductor device) may include a step of displaying a screen by a display method described later.

In other words, the program causes the computer to execute a procedure of displaying a plurality of indicators 72 indicating the recipes including the sub-recipes or the main recipes on the recipe selection image 60. The program also causes the computer to execute a procedure of displaying a recipe editing image 80 on the screen of the display 204 when one of the indicators 72 is selected on the recipe selection image 60. The recipe editing image 80 may include: a management information display area 68 in which management information associated with the indicator selected as described above can be displayed; and the combination information editing area 70 in which combination information linked to the recipe displayed in the management information display area 68 can be displayed.

Subsequently, the display method of displaying on the screen of the display 204 according to the present embodiments will be described with reference to FIGS. 4 to 6.

### <Screen Display and Combination Information>

FIGS. 4 to 6 are diagrams schematically illustrating examples of a screen display according to the present disclosure, in which the recipe selection image 60 including the recipe selection area 62 and a recipe editing area 64 is displayed on the screen. More specifically, according to the present embodiments, for example, the recipe selection area 62 is displayed on a left side of the screen, and the recipe editing area 64 is displayed on a right side of the screen to be close to each other.

In the recipe selection area 62, the plurality of main recipes, a plurality of sub-recipes and a plurality pieces of parameter data stored in the memory 104 are displayed. More specifically, names of each recipe and the parameter data are displayed as character strings in the recipe selection area 62, and each of the indicators 72 can be selected by the operator by touching the screen. In FIG. 4, an example where a main recipe "MR3" is selected is shown.

In the recipe editing area 64, the recipe selected in the recipe selection area 62 is displayed such that the recipe can be edited. For example, in FIG. 4, when the main recipe "MR3" is selected among the main recipes, steps included in the recipe (that is, the main recipe "MR3) are displayed in the recipe editing area 64. More specifically, in the recipe editing area 64, sub-recipes and parameter data cited by each step in the main recipe "MR3" are displayed. Each of the indicators 72 of the steps displayed in the recipe editing area 64 can be selected by the operator by touching the screen. When each step is selected, contents of the step are displayed separately such that the operator can edit the contents of the step (not shown).

That is, FIG. 4 is a diagram schematically illustrating an example of the screen displayed by the step of displaying the plurality of indicators 72 indicating the recipes (including the sub-recipes or the main recipes) on the recipe selection image 60.

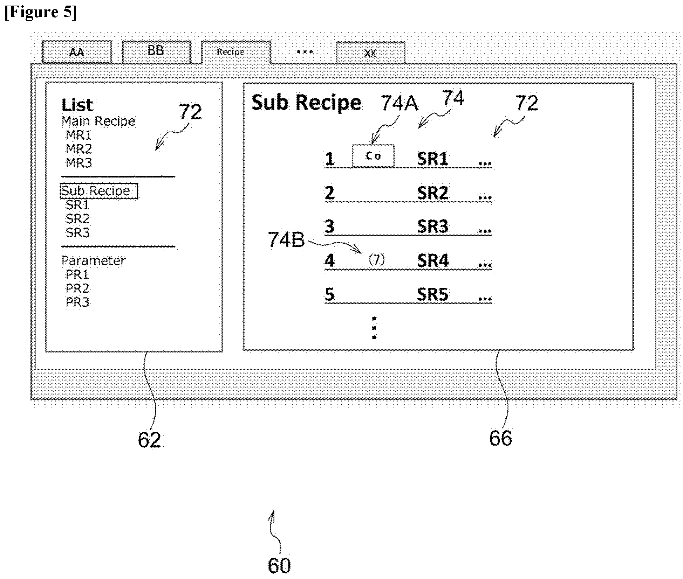

FIG. 5 is a diagram schematically illustrating the screen when the recipe selection area 62 is selected to display a list of the sub-recipes. As an example, the list of the sub-recipes is displayed in a second recipe selection area 66 on the right side of the screen by selecting the indicator 72 for an item "sub-recipe" ("Sub Recipe" in FIG. 5) from the list in the recipe selection area 62. The second recipe selection area 66 is another example of the recipe selection area 62 in the present embodiments.

As shown in FIG. 5, in the second recipe selection area 66, a list of the names of the sub-recipes stored in the memory 104 is displayed. Further, in the second recipe selection area 66 according to the present embodiments, each name of the sub-recipe may be displayed with a link display icon 74. For example, an icon indicating a presence of a link may be displayed, such as a link display icon 74A. In addition, when each sub-recipe is cited by the main recipe, the link display icon 74 may be changed depending on the number of cited main recipes. More specifically, a link display character 74B may be displayed by using a character corresponding to the number of the main recipes that cite the sub-recipe. According to the present embodiments, when seven main recipes are linked to the sub-recipe "SR4" as shown in FIG. 5, "(7)" is displayed as the link display character 74B with respect to the sub-recipe "SR4". In addition, according to the present embodiments, when the number of cited main recipes for each sub-recipe is 0 (that is, when the sub-recipe is not cited in any main recipe), the link display icon 74 is not displayed. Further, when there is no main recipe that cites the sub-recipe, "(0)" may be displayed as the link display character 74B corresponding to the number of main recipes that cite the sub-recipe.

That is, FIG. 5 is a diagram schematically illustrating another example of the screen displayed by the step of displaying the plurality of indicators 72 indicating the recipes (including the sub-recipes or the main recipes) on the recipe selection image 60.

FIG. 6 is a diagram schematically illustrating the recipe editing image 80 including the management information display area 68 and the combination information editing area 70. More specifically, according to the present embodiments, for example, the management information display area 68 is displayed on the left side of the screen, and the combination information editing area 70 is displayed on the right side of the screen to be close to each other.

In the management information display area 68, the management information for the sub-recipe (for example, the sub-recipe "SR2" shown in FIG. 6) selected from the plurality of sub-recipes displayed in FIG. 4 or FIG. 5 is displayed. More specifically, in the management information display area 68, the name of the sub-recipe, the parameter data to be cited and the combination information described below are displayed. In other words, the controller 101 displays detailed information of the combination information in the combination information editing area 70.

According to the present embodiments, the "combination information" may refer to a list of main recipes that cite the sub-recipe. When the combination information is selected, details of the combination information corresponding thereto are displayed in the combination information editing area 70. Further, in the combination information editing area 70, a list of the main recipes (serving as the combination information) that cite the sub-recipe and buttons that serve to accept editing each main recipe are arranged and displayed.

As an example of buttons that serve to accept editing of the main recipe, according to the present embodiments, three buttons (that is, a first edit button 76A, a second edit button 76B and a third edit button 76C) are displayed for each main recipe.

When the operator selects the first edit button 76A, the first edit button 76A causes the controller 101 to execute a process displayed on the screen (that is, the screen shown in FIG. 4) for editing the steps included in the main recipe. In other words, when the operator selects the first edit button 76A, the first edit button 76A causes the controller 101 to display a screen for editing the recipe associated with the first edit button 76A.

Further, when the operator selects the second edit button 76B, the second edit button 76B causes the controller 101 to execute a process of deleting the main recipe (erasing the main recipe from the memory 104).

Further, when the operator selects the third edit button 76C, the third edit button 76C causes the controller 101 to execute a process of eliminating a citation relationship between the selected sub-recipe and the main recipe. In the present specification, for example, the term "process of eliminating the citation relationship" between the sub-recipe and the main recipe may refer to a process of directly writing the parameter data or the steps of the sub-recipe into the main recipe, or may refer to a process of ignoring the steps of citing the sub-recipe by the main recipe. In other words, in a case where the operator selects the third edit button 76C, the third edit button 76C causes the controller 101 to prevent a result of editing the sub-recipe from affecting the main recipe even when the sub-recipe is edited.

In other words, FIG. 6 is a diagram schematically illustrating another example of the screen displayed by the step of displaying the recipe editing image 80 on the screen when one of the indicators 72 is selected on the recipe selection image 60. As described above, the recipe editing image 80 includes: the management information display area 68 in which the management information associated with the indicator selected as described above can be displayed; and the combination information editing area 70 in which the combination information linked to the recipe displayed in the management information display area 68 can be displayed.

Further, according to the present embodiments, the combination information may be created in an appropriate manner.

As an example, the combination information may refer to data created when the substrate processing apparatus 10 is started up and the CPU 102 refers to each of the main recipes stored in the memory 104 and detects the names of the sub-recipes referenced by each main recipe. Further, in such a case, the combination information is stored as data in the memory 104, and when the combination information is selected as shown in FIGS. 5 and 6, the data of the combination information is read from the memory 104. In such a case, since the combination information is automatically created by the CPU 102, it is possible to reduce the burden on the operator. Further, in such a case, it is possible to promptly update the combination information when the main recipe is created or edited.

Further, as another example, the combination information may refer to data of a portion (of the sub-recipe) that is added as meta information such as a header of the sub-recipe when the operator creates or edits the sub-recipe. In such a case, when the management information display area 68 shown in FIG. 6 is displayed, the portion of the sub-recipe (that is, the combination information) is read together with the management information of the sub-recipe. In such a case, since the combination information is stored as sub-recipe data, it is possible to reduce a size of the data stored in the memory 104 as compared with a case where the CPU 102 automatically creates the combination information as the data. Further, in such a case, it is possible to start up the substrate processing apparatus 10 faster as compared with a case where the CPU 102 automatically creates the combination information as the data.

Subsequently, actions of the substrate processing apparatus 10 according to the present embodiments and one or more effects obtained by the substrate processing apparatus 10 will be described.

### <Actions and Effects>

In the substrate processing apparatus 10 according to the present embodiments, the controller 101 is configured to be capable of controlling the screen of the display 204 to display the recipe selection image 60 and the recipe editing image 80. As a result, according to the substrate processing apparatus 10 according to the present embodiments, it is possible for the operator to easily identify other recipes associated with a specific recipe in the substrate processing apparatus 10 capable of storing the plurality of main recipes.

Further, in the substrate processing apparatus 10 according to the present embodiments, the controller 101 is configured to be capable of displaying the button that serves to accept editing of the combination information in the combination information editing area 70. Therefore, according to the substrate processing apparatus 10 according to the present embodiments, since the button that serves to accept editing of the combination information can be displayed, it is possible for the operator to easily select an object to be edited.

Further, in the substrate processing apparatus 10 according to the present embodiments, the controller 101 is configured to be capable of displaying a link state between the sub-recipe and the main recipe in the recipe selection area 62. Therefore, according to the substrate processing apparatus 10 according to the present embodiments, it is possible for the operator to easily understand the link state between the sub-recipe and the main recipe. More specifically, since the operator can easily understand the recipes that are not linked to the sub-recipe, it is possible for the operator to easily determine whether or not the recipe displayed on the screen is redundant (unnecessary).

Further, in the substrate processing apparatus 10 according to the present embodiments, the controller 101 is configured to be capable of displaying the icon indicating whether or not the sub-recipe and the main recipe are linked to each other. Therefore, according to the substrate processing apparatus 10 according to present embodiments, it is possible for the operator to easily understand the link state between the sub-recipe and the main recipe by checking the icon displayed on the screen.

Further, in the substrate processing apparatus 10 according to the present embodiments, the controller 101 is configured to be capable of displaying the indicators 72 indicating the plurality of sub-recipes and the icon indicating whether or not the sub-recipes are linked to the main recipe in the recipe selection area 62. Therefore, according to the substrate processing apparatus 10 according to present embodiments, it is possible for the operator to easily understand the link state between the sub-recipes and the main recipe.

Further, in the substrate processing apparatus 10 according to the present embodiments, the controller 101 is configured to be capable of displaying the indicators 72 indicating the plurality of sub-recipes and the icon indicating the number of the main recipes linked to the sub-recipe in the recipe selection area 62. Therefore, according to the substrate processing apparatus 10 according to present embodiments, it is possible for the operator to easily grasp (understand) the number of the main recipes linked to the sub-recipe, and therefore, it is possible for the operator to easily grasp the effects of editing the sub-recipe.

Further, in the substrate processing apparatus 10 according to the present embodiments, the sub-recipe is configured to link with a plurality of main recipes, and a maximum number of the steps that the main recipe can handle is set to be smaller than the number of the steps that the sub-recipe can handle. According to the present embodiments, since the maximum number of the steps that the sub-recipe can handle is greater than the maximum number of the steps that the main recipe can handle, regarding a degree of freedom in editing an apparatus control in a recipe, the degree of freedom of the sub-recipe is higher than the degree of freedom of the main recipe. Therefore, according to the substrate processing apparatus 10 according to the present embodiments, when editing the recipe, it is possible for the operator to leave (or maintain) the sub-recipe and to delete the main recipe.

Further, in the substrate processing apparatus 10 according to the present embodiments, the buttons that serve to accept editing may comprise a button that serves to switch the current image to an editing image for the recipe associated with each piece of the combination information. Therefore, according to the substrate processing apparatus 10 according to present embodiments, when editing the recipe, it is possible for the operator to easily check the combination information of the sub-recipe and the main recipe and then to quickly edit the main recipe.

Further, in the substrate processing apparatus 10 according to the present embodiments, the buttons that serve to accept editing may comprise a button that serves to accept severing (or cutting off) the link between the sub-recipe and the main recipe displayed in the combination information editing area 70. Therefore, according to the substrate processing apparatus 10 according to the present embodiments, when editing the recipe, it is possible to prevent the result of editing the sub-recipe from affecting the main recipe even when the operator edits the sub-recipe.

Further, in the substrate processing apparatus 10 according to the present embodiments, one of the buttons that serve to accept editing may comprise a button that serves to delete the main recipe associated with the sub-recipe displayed in the combination information editing area 70. Therefore, according to the substrate processing apparatus 10 according to the present embodiments, when editing the recipe, it is possible for the operator to easily and quickly delete the main recipe after checking the combination information between the sub-recipe and the main recipe.

Further, in the substrate processing apparatus 10 according to the present embodiments, the controller 101 is configured to be capable of locating the management information display area 68 and the combination information editing area 70 to be close to each other. Therefore, according to the substrate processing apparatus 10 according to the present embodiments, it is possible for the operator to easily compare the management information display area 68 and the combination information editing area 70 of each recipe.

Further, in the substrate processing apparatus 10 according to the present embodiments, the controller 101 is configured to be capable of displaying the information indicating one or both of the sub-recipe and the main recipe in the management information display area 68. Further, the controller 101 is configured to be capable of displaying a plurality pieces of the combination information linked to the sub-recipe or the main recipe, and configured to be capable of displaying the detailed information of the combination information (which is selected in the management information display area 68) in the combination information editing area 70. Therefore, according to the substrate processing apparatus 10 according to the present embodiments, it is possible for the operator to quickly select other pieces of combination information in the management information display area 68, and thereby, it is possible for the operator to edit the combination information while paying attention to the other pieces of combination information.

Further, in the substrate processing apparatus 10 according to the present embodiments, the controller 101 is configured to be capable of displaying the combination information associated with the recipe (which is selected on the recipe selection image 60) in the management information display area 68. Therefore, according to the substrate processing apparatus 10 according to the present embodiments, it is possible for the operator to easily grasp the combination information selected on the recipe selection image 60 and the details of the combination information.

### <Other Embodiments of Present Disclosure>

For example, the embodiments mentioned above are described by way of an example in which the combination information is the list of the main recipes that cite the sub-recipe. However, the technique of the present disclosure is not limited thereto. For example, the combination information may be created similarly for parameter data cited by the sub-recipe. For example, when the sub-recipe or the main recipe cites the parameter data, the combination information may be created as a list of the sub-recipes or the list of the main recipes that cite the parameter data.

That is, the combination information according to the embodiments mentioned above may refer to information indicating a relationship between main procedure information and subsidiary procedure information cited in the main procedure information. In the above description, the relationship between the main recipe and the sub-recipe cited in the main recipe may correspond to the relationship between the main procedure information and the subsidiary procedure information. For example, in the above description, the recipe includes the main recipe and the sub-recipe. However, the recipe may further include other types of recipes cited by the sub-recipe. In other words, the combination information may be created in the same manner as described above for the other types of recipes cited by the sub-recipe alone.

For example, the embodiments mentioned above are described by way of an example in which the controller 101 is provided as a part of a configuration of the substrate processing apparatus 10. However, the technique of the present disclosure is not limited thereto. For example, the controller 101 may be provided separately from the substrate processing apparatus 10. That is, the technique of the present disclosure may also be applied when a processing apparatus provided without the process chamber 34 is configured to process the substrate 200 by controlling the substrate processing apparatus 10 (which is provided separately from the processing apparatus) via a communication interface such as the network.

For example, the embodiments mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates is used to form the film. For example, the embodiments mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film. Further, the technique of the present disclosure is not limited thereto. For example, the technique of the present disclosure may also be applied to another substrate processing apparatus such as a diffusion apparatus, an annealing apparatus and an oxidation apparatus.

The process procedures and the process conditions of each process using the substrate processing apparatuses exemplified above may be substantially the same as those of the embodiments or modified examples mentioned above. Even in such a case, it is possible to obtain substantially the same effects as in the embodiments or the modified examples mentioned above.

For example, the substrate is not limited to the wafer described above. For example, a structure such as a photomask, a printed wiring substrate, a liquid crystal panel, a compact disk and a magnetic disk may be used as the substrate.

In addition, the processing executed by the CPU 102 by reading the program (software) in each of the embodiments mentioned above may be executed by various processors other than the CPU 102. In such a case, for example, a PLD (Programmable Logic Device) such as an FPGA (Field Programmable Gate Array) whose circuit configuration can be changed after manufactured and a dedicated electrical circuit including a circuit configuration designed exclusively for executing a specific process such as an ASIC (Application Specific Integrated Circuit) may be used as such a processor. The processing may be executed by one of the various processors, or may be executed by a combination of two or more processors of the same or different types (for example, a plurality of FPGAs or a combination of the CPU 102 and the FPGA). More specifically, a hardware structure of each of the various processors is an electric circuit that combines circuit elements such as semiconductor devices.

For example, the embodiments mentioned above are described by way of an example in which the program for processing the substrate is stored (installed) in the memory 104 in advance. However, the technique of the present disclosure is not limited thereto. For example, the program may be provided in a form stored in a non-transitory storage medium (recording medium) such as the CD-ROM (Compact Disk Read Only Memory), the DVD-ROM (Digital Versatile Disk Read Only Memory) and the USB (Universal Serial Bus) memory. The program may be downloaded from the external apparatus via the network.

The invention may be summarized as follows: There is provided a technique capable of easily identifying a recipe and combination information associated with the recipe in a processing apparatus. There is provided a technique that includes: a controller configured to be capable of controlling a screen to display a recipe selection image including a recipe selection area and a recipe editing image including a management information display area and a combination information editing area, wherein the recipe selection area is configured such that a plurality of indicators indicating a plurality of recipes including a plurality of sub-recipes or a plurality of main recipes are displayed therein, wherein the management information display area is configured such that, when one of the plurality of indicators is selected on the recipe selection image, management information of one of the plurality of recipes associated with the one of the plurality of indicators selected on the recipe selection image is capable of being displayed therein, and wherein the combination information editing area is configured such that combination information linked to the one of the plurality of recipes displayed in the management information display area is capable of being displayed therein.

While the embodiments of the present disclosure are described above with reference to the drawings, it is apparent to those skilled in the art that the technique of the present disclosure may be modified to obtain various modified examples and applications within the scope of the technical idea described in the claims. It is also apparent to those skilled in the art that various modified examples and applications described above also fall within the technical scope of the present disclosure.

**[Description of Reference Numerals]**

| | | | |
|---|---|---|---|
| 62 | Recipe selection area | 60 | Recipe selection screen |
| 68 | Management information display area | | |
| 70 | Combination information editing area | | |
| 72 | Indicators | 80 | Recipe editing screen |
| 101 | Controller | | |

## Claims

1. A processing apparatus comprising
a controller configured to be capable of controlling a screen to display a recipe selection image comprising a recipe selection area and a recipe editing image comprising a management information display area and a combination information editing area,
wherein the recipe selection area is configured such that a plurality of indicators indicating a plurality of recipes comprising a plurality of sub-recipes or a plurality of main recipes are displayed therein,
wherein the management information display area is configured such that, when one of the plurality of indicators is selected on the recipe selection image, management information of one of the plurality of recipes associated with the one of the plurality of indicators selected on the recipe selection image is capable of being displayed therein, and
wherein the combination information editing area is configured such that combination information linked to the one of the plurality of recipes displayed in the management information display area is capable of being displayed therein.

2. The processing apparatus of claim 1, wherein the controller is further configured to be capable of displaying a button that serves to accept editing of the combination information in the combination information editing area.

3. The processing apparatus of claim 1 and/or 2, wherein the controller is further configured to be capable of displaying, in the recipe selection area, a link state between a sub-recipe among the plurality of sub-recipes and a main recipe among the plurality of main recipes, or an icon indicating whether or not the sub-recipe is linked to the main recipe.

4. The processing apparatus of any one or more of claims 1 to 3, wherein the controller is further configured to be capable of displaying, in the recipe selection area, the plurality of indicators indicating the plurality of sub-recipes and an icon indicating whether or not a sub-recipe among the plurality of sub-recipes is linked to a main recipe among the plurality of main recipes, or the plurality of indicators indicating the plurality of sub-recipes and an icon indicating number of the main recipes linked to the sub-recipe.

5. The processing apparatus of any one or more of claims 1 to 4, wherein a sub-recipe among the plurality of sub-recipes is configured to link with two or more main recipes among the plurality of main recipes.

6. The processing apparatus of any one or more of claims 1 to 5, in particular of claim 5, wherein a single main recipe among the plurality of main recipes is configured to link with a single sub-recipe among the plurality of sub-recipes.

7. The processing apparatus of any one or more of claims 1 to 6, wherein a single sub-recipe among the plurality of sub-recipes is configured to link with two or more main recipes among the plurality of main recipes, and
wherein a maximum number of steps capable of being handled by each of the two or more main recipes is set to be smaller than a number of steps capable of being handled by the single sub-recipe.

8. The processing apparatus of any one or more of claims 2 to 7, wherein the button comprises at least one among:
a button that serves to switch a current image to an editing image for a recipe among the plurality of recipes associated with the combination information;
a button that serves to accept severing a link between a sub-recipe among the plurality of sub-recipes and a main recipe among the plurality of main recipes displayed in the combination information editing area; and
a button that serves to delete the main recipe associated with the sub-recipe and displayed in the combination information editing area.

9. The processing apparatus of any one or more of claims 1 to 8, wherein the controller is further configured to be capable of locating the management information display area to be close to the combination information editing area.

10. The processing apparatus of any one or more of claims 1 to 9, wherein the controller is further configured to be capable of displaying, in the management information display area, information indicating one or both of a sub-recipe among the plurality of sub-recipes and a main recipe among the plurality of main recipes and a plurality pieces of the combination information linked to the sub-recipe or the main recipe or the combination information associated with the one of the plurality of recipes selected on the recipe selection image, and
the controller is further configured to be capable of displaying, in the combination information editing area, detailed information of one or more pieces of the combination information selected in the management information display area.

11. A substrate processing apparatus comprising:
the processing apparatus of any one or more of claims 1 to 10; and
a process chamber in which a substrate is capable of being processed.

12. A display method comprising
(a) displaying a plurality of indicators indicating a plurality of recipes comprising a plurality of sub-recipes or a plurality of main recipes on a recipe selection image; and
(b) displaying a recipe editing image comprising a management information display area and a combination information editing area on a screen when one of the plurality of indicators is selected on the recipe selection image,
wherein the management information display area is configured such that management information of one of the plurality of recipes associated with the one of the plurality of indicators selected on the recipe selection image is capable of being displayed therein, and
wherein the combination information editing area is configured such that combination information linked to the one of the plurality of recipes displayed in the management information display area is capable of being displayed therein.

13. A substrate processing method comprising
processing a substrate based on the one of the plurality of recipes displayed on the recipe selection image in the display method of claim 12.

14. A method of manufacturing a semiconductor device, comprising
processing a substrate based on the one of the plurality of recipes displayed on the recipe selection image in the display method of claim 12.

15. A program that causes a substrate processing apparatus, by a computer, to perform:
(a) displaying a plurality of indicators indicating a plurality of recipes comprising a plurality of sub-recipes or a plurality of main recipes on a recipe selection image; and
(b) displaying a recipe editing image comprising a management information display area and a combination information editing area on a screen when one of the plurality of indicators is selected on the recipe selection image,
wherein the management information display area is configured such that management information of one of the plurality of recipes associated with the one of the plurality of indicators selected on the recipe selection image is capable of being displayed therein, and
wherein the combination information editing area is configured such that combination information linked to the one of the plurality of recipes displayed in the management information display area is capable of being displayed therein.
